Europäisches Patentamt

European Patent Office

Office européen des brevets

(19)

(11) EP 1 498 803 A2

(12) **EUROPÄISCHE PATENTANMELDUNG**

| | |
|---|---|
| (43) Veröffentlichungstag:<br>**19.01.2005  Patentblatt 2005/03** | (51) Int Cl.7: **G06F 1/26**, H03M 5/08,<br>G11B 20/10 |

(21) Anmeldenummer: **04006659.9**

(22) Anmeldetag: **19.03.2004**

| | |
|---|---|
| (84) Benannte Vertragsstaaten:<br>**AT BE BG CH CY CZ DE DK EE ES FI FR GB GR**<br>**HU IE IT LI LU MC NL PL PT RO SE SI SK TR**<br>Benannte Erstreckungsstaaten:<br>**AL LT LV MK** | (72) Erfinder:<br>• **Lücking, Dieter, Dipl.-Ing.**<br>  **79110 Freiburg (DE)**<br>• **Alrutz, Herbert, Dr.**<br>  **79102 Freiburg (DE)**<br>• **Vierthaler, Matthias, Dipl.-Ing.**<br>  **79211 Denzlingen (DE)** |
| (30) Priorität: **14.07.2003  US 487000 P**<br>           **14.08.2003  DE 10337782** | |
| (71) Anmelder: **Micronas GmbH**<br>     **79108 Freiburg (DE)** | (74) Vertreter:<br>**Patentanwälte Westphal, Mussgnug & Partner**<br>**Am Riettor 5**<br>**78048 Villingen-Schwenningen (DE)** |

(54)    **Methode und Schaltung zur effektiven Konvertierung vom PCM- in PWM-Daten**

(57)    Die Erfindung bezieht sich auf ein Verfahren und eine Vorrichtung zum Umwandeln eines digitalen, pulskodierten kodierten Signals (PCM) in ein pulsweiten-moduliertes Signal (PWM), bei dem das digitale Signal PCM, f(t) mit zumindest einer Ableitung (f'(t), f''(t)....., $f^{(n)}(t)$) des Signals (f(t)) multipliziert wird. Gemäß eigenständiger erfinderischer Ausgestaltung bezieht sich die Erfindung außerdem auf ein Verfahren zum Umwandeln eines digitalen pulskodierten Signals (PCM) in ein pulsweiten-moduliertes Signal (PWM), bei dem zum Erzielen einer für das pulsweiten-modulierte Signal ausreichenden Abtastrate eine Überabtastung des digitalen Signals zu einem erforderlichen Überabtastfaktor durchgeführt wird, wobei eine Überabtastung mit einem Überabtastfaktor vor und eine Überabtastung mit einem weiteren Überabtastfaktor nach dem Umwandeln durchgeführt wird, so dass das Produkt der Überabtastfaktoren vor und nach dem Umwandeln des digitalen Signals in das pulsweiten-modulierte Signal mindestens dem Wert des erforderlichen Überabtastfaktors entspricht.

Fig. 1

EP 1 498 803 A2

**Beschreibung**

Die Erfindung bezieht sich auf ein Verfahren zum Umwandeln eines digitalen Signals, insbesondere PCM-Signals, in ein pulsweiten-moduliertes Signal mit den oberbegrifflichen Merkmalen des Patentanspruchs 1 oder 8 bzw. eine Vorrichtung zum Umwandeln solcher Signale.

Aus verschiedenen technischen Gebieten sind Verfahren und Vorrichtungen zum Umwandeln eines digitalen Signals mittels Pulsweiten-Modulation in ein analoges Signal bekannt. Neben Systemen für Motorensteuerungen, Kalibrierungsschaltungen, Schaltnetzteilen, Gleichspannungswandlern, digitalen Verstärkern sind beispielsweise auch derart funktionierende digitale Audio-Verstärker bekannt.

Üblicherweise liegt das digitale Signal als PCM-Signal (PCM: Pulse Code Modulated) vor, welches beispielsweise ein Musiksignal von einem CD-Spieler (CD: Kompaktdisk) oder desgleichen repräsentiert. PCM-Signale bieten eine Vielzahl von Vorteilen gegenüber analogen Signalen, beispielsweise die Möglichkeit der exakten Signalverarbeitung ohne Einfluss von Bauteiletoleranzen. Im Audio Bereich üblich ist jedoch nach der digitalen Signalverarbeitung die Rückwandlung in ein analoges Signal, das dann einem analogen Leistungsverstärker zugeführt wird. Wünschenswert ist auf Grund geringerer Verlustleistung allerdings der Einsatz digitaler Leistungsverstärker, deren Wirkungsgrad wesentlich höher liegt als der von analogen. Dazu wird das PCM-Signal, bei dem jeweils ein PCM-Signalwert innerhalb eines vorgegebenen Zeitintervalls auftritt, in ein digitales pulsweiten-moduliertes Signal (PWM-Signal) umgesetzt, in welchem die zu übertragende Information durch die Pulsweite kodiert ist. Das PWM-Signal wird daraufhin in einem digitalen Schaltverstärker verstärkt und schließlich in das eigentliche analoge Signal umgewandelt.

Als NPWM (Natural Sampling Pulse Width Modulation)-Verfahren ist eine Methode bekannt, bei der das zeitkontinuierliche Eingangssignal mittels einer vorgegebenen zeitkontinuierlichen Rampenfunktion abgetastet wird, wobei die Pulsweite des zu erzeugenden PWM-Signals anhand des Schnittpunkts des zeitkontinuierlichen Eingangssignals mit der Rampenfunktion bestimmt wird. Dieses Verfahren wird auch als analoge PWM bezeichnet, da das analoge Eingangssignal ohne Umweg der PCM-Codierung direkt in das PWM-Signal gewandelt wird.

Alternativ dazu sind digitale PWM Verfahren bekannt, die aus diskreten Abtastwerten des kontinuierlichen Eingangssignals die PWM Pulsweiten errechnen.

Bekannt ist ein sog. UPWM (Uniform Sampling Pulse Width Modulation)-Verfahren, welches die Pulsweiten linear aus den (PCM-) Abtastwerten errechnet. Da die spätere Digital/Analog-Wandlung des so erzeugten PWM Signals aber ein nicht linearer Prozess ist, ergibt das gesamte UPWM Verfahren hohe Nicht-Linearitäten.

Aus DE 101 56 744 A1 ist ein Verfahren bekannt, bei dem zu den einzelnen PCM-Signalwerten Zwischenwerte interpoliert werden und bei dem Vergleichswerte in Rampenfunktion zu den entsprechenden Abtast-Stützstellen bestimmt werden. Eine Auswerteeinheit zur Erzeugung des PWM-Signals vergleicht die interpolierten PCM-Signalwerte mit den rampenförmig verlaufenden Vergleichswerten.

Letztendlich entspricht auch dieses Verfahren vom Grundgedanken her einem Verfahren, bei dem eine analoge oder digitalisierte Signalamplitude mit der Amplitude eines höher frequenten Referenzsignals, beispielsweise eines Sägezahnsignals, verglichen wird, um ein pulsweiten-moduliertes Signal zu erzeugen. Ein solches Signal kann unter Verwendung eines Digital/Analog-Wandlers in ein Analogsignal zurückverwandelt werden. Bei der Verwendung von PWM-Signalen kann der Digital/Analog-Wandler im wesentlichen aus einem relativ einfachen Tiefpassfilter bestehen. In der klassischen (analogen) PWM-Schaltung wird der exakte Schnittpunkt zwischen dem Eingangssignal und dem Bezugssignal verwendet, um einen Komparator als Vergleicherschaltung zum Umschalten des Ausgangssignalwertes zwischen zwei diskreten Zuständen zu schalten. Erzeugt wird das natürlich abgetastete PWM-Signal (NPWM). Das NPWM-Signal enthält nach der D/A-Wandlung keine direkten harmonischen Schwingungen des Eingangssignals sondern nur höher frequente Intermodulationsprodukte zwischen dem Eingangssignal und dem Referenzsignal, welche in dem Digital/Analog-Prozess durch den Tiefpassfilter herausgefiltert werden. Digitale PCM-zu-PWM-Umwandlungsschaltungen, wie beispielsweise gemäß DE 101 56 744 A1, müssen das Verhalten einer entsprechenden analogen Schaltung so genau wie möglich nachahmen. Beschränkungen ergeben sich für Echtzeitanwendungen derzeit durch die erforderliche Verarbeitungszeit und die Pulsweiten-Auflösung bzw. Anzahl von Bit. Diesbezüglich sind verschiedenen Verfahren bekannt, wie folgt.

Ein Verfahren zum Umwandeln von PCM-Daten in PWM-Daten besteht in einem linearen Abbilden von jedem PCM-Signalwert bzw. PCM-Abtastwert auf eine entsprechende PWM-Pulsweite, wie dies beispielsweise durch Erik Bresch und Wayne T. Padgett beschrieben wird (TMS320C67-Based Design of a Digital Audio Power Amplifier introducing novel feedback strategy). Diese Abbildung ist die sog. uniform abgetastete Pulsweiten-Modulation (UPWM). Dieses Verfahren erzeugt jedoch eine große Menge direkter harmonischer Schwingungen des ursprünglichen Signals und ist daher für Audioanwendungen nicht geeignet.

Falls die PWM-Abtastperiode Null angenähert wird, nimmt der Unterschied zwischen der Pulsweite gemäß UPWM und NPWM für die gleiche Eingangswellenform auf Null ab. Dies ist äquivalent zu einer unendlich großen PWM-Pulsrate.

Um den Ausgangs-Tiefpassfilter einfach zu halten, wird als Pulsrate zumindest das 10-20-fache der Bandbreite des abgetasteten Ausgangssignals bevorzugt. Für Audioanwendungen beträgt die typische Bandbreite 20 kHz weshalb eine Pulsrate von 200 ... 400 kHz verwendet wird. Bevorzugt würde eine höhere Pulsrate, jedoch nimmt die Effizienz derzeitiger Leistungsschalter jenseits von 1 MHz drastisch ab, was den allgemeinen Vorteil eines digitalen Schaltverstärkers reduziert. In der Praxis werden daher Pulsraten zwischen 200 kHz und 1,5 MHz bevorzugt.

Ein weiterer Faktor ist die minimale Pulsbreite. Da in einem digitalen System nur diskrete Pulsbreiten möglich sind, bestimmt die minimale Pulsbreite die Auflösung und folglich die PWM-Taktfrequenz. Für eine PWM-Pulsrate von 384 kHz und eine Auflösung von 16 Bit, d.h. CD-Qualität, würde die PWM-Taktfrequenz 384 kHz $\times$ $2^{16}$, d.h. 25,16 GHz betragen. Eine derart hohe Taktfrequenz ist offensichtlich nicht praktikabel verarbeitbar. Um PWM-Verstärker, insbesondere für Audioanwendungen, zu realisieren, wurden verschiedene Verfahren vorgeschlagen, diese Beschränkungen zu bewältigen.

Aus WO 92/11699 ist ein Verfahren zur Umwandlung eines PCM-Signals in ein PWM-Signal bekannt, bei welchem ein Überabtastfilter (Over Sampling Filter) vor der PCM-zu-PWM-Umwandlung eingesetzt wird, um die Audio-Abtastrate von 44,1 kHz oder 48 kHz zu einer PWM-Rate von 352,8 kHz bzw. 384 kHz zu erhöhen. Zusätzlich wird eine Polynominterpolation zusammen mit einer sog. Newton-Raphson-Iteration vorgeschlagen, um die exakten Schnittpunkte eines begrenzten Satzes diskreter Abtastpunkte zu berechnen. Außerdem wird ein sog. Noise Shaper (Rauschformungsschaltung) vorgeschlagen, um die Auflösung des diskreten pulsbreiten-modulierten Signals zu verbessern. Nachteilhafterweise muss für praktische Anwendungen ein Polynom von zumindest dem 3-ten Grad verwendet werden und es sind zumindest zwei Iterationsschritte erforderlich, um Signale mit einer guten Audioqualität zu erzielen. Beide Berechnungen sind mit der letztendlichen PWM-Pulswiederholungsrate von 352,8 bzw. 384 kHz zu berechnen, was hohe Rechnungsleistung erforderlich macht.

Neben der aufgeführten PCM-zu-PWM-Umwandlung im Zeitbereich zur Annäherung der Nicht-Linearitäten bei der PWM-Digital/Analog-Umwandlung ist aus WO 97/37433 eine Annäherung im Frequenzbereich bekannt. Das Verfahren beruht auf einer Modellierung und daher einer Vorhersage der Nicht-Linearität des PWM-Digital/Analog-Umwandlungsprozesses. Dazu wird die Verwendung eines sog. Hammerstein-Filters zum Korrigieren der Nicht-Linearitäten des Umwandlungsprozesses vorgeschlagen. Durch Vorhersagen der Amplitude und Phase der harmonischen Schwingungen, welche durch den PWM-Digital/Analog-Umwandlungsprozess entstehen, können harmonische Einflüsse vor der Digital/Analog-Umwandlung berücksichtigt werden, so dass diese harmonischen Schwingungen und die harmonischen Schwingungen des PWM-Digital/Analog-Prozesses einander letztendlich auslöschen.

Ein dazu vollständig andersartiges Verfahren nach Streitenberger et al. (Zero Position Coding (ZePoC) - A Generalized Concept of Pulse-Length Modulated Signals and its application to Class-D Audio Power Amplifiers, 110-te AES Convention, 12. bis 15. Mai 2001) verwendet eine analytische exponentielle Modulation, um das PWM-Signal zu erzeugen, was eine niedrigere Puls-Wiederholfrequenz erzeugt, wobei diese für Audioanwendungen niedriger als 100 kHz ist. Die von Streitenberger et al. vorgeschlagene Audioimplementierung macht drei Einrichtungen zur digitalen Signalverarbeitung (DSP engines) erforderlich, um dieses komplexe Verfahren mit einem sehr großen Rechenaufwand (233 MMACs - 233.000.000 Multiplikations- und Additionsschritte) zu betreiben.

Die Aufgabe der Erfindung besteht darin, ein Verfahren und eine Vorrichtung zum Umwandeln eines digitalen Signals, insbesondere eines PCM-Signals, in ein pulsweiten-moduliertes Signal zu verbessern, so dass Effizienz und Rechenaufwand reduziert werden und dabei gleichzeitig eine hohe Linearität des gesamten Wandlungsverfahrens (PCM->PWM->D/A) gewährleistet wird.

Diese Aufgabe wird durch ein Verfahren zum Umwandeln eines digitalen Signals in ein pulsweiten-moduliertes Signal mit den Merkmalen des Patentanspruchs 1 bzw. eine Vorrichtung zum Umwandeln eines digitalen Signals, insbesondere PCM-Signals, in ein pulsweiten-moduliertes Signal mit den Merkmalen des Patentanspruchs 9 gelöst. Eine bevorzugte vorteilhafte Ausgestaltung mit eigenständigem erfinderischem Gehalt ist Gegenstand des Verfahrensanspruchs 8 bzw. des Vorrichtungsanspruchs 12.

Gemäß der besonders bevorzugten Ausführungsform weist ein Verfahren zum Umwandeln eines digitalen kodierten Signals, insbesondere pulskodierten Signals (PCM), in ein pulsweiten-moduliertes Signal (PWM) den Schritt auf, dass das digitale Signal mit zumindest einer Ableitung bzw. Signalwerte mit entsprechenden Ableitungswerten des Signals multipliziert wird. Eine entsprechende Vorrichtung weist eine Schaltungsanordnung zum Berechnen des pulsweiten-modulierten Signals aus Ableitungen des digitalen Signals und Multiplikationen der Ableitungen mit dem digitalen Signal auf.

Vorteilhafte Ausgestaltungen sind Gegenstand von abhängigen Ansprüchen.

Das Signal wird in bevorzugter Ausführungsform aus linearen und/oder nicht-linearen Termen zusammengesetzt, wobei mindestens einer der Terme einen Ableitungswert bzw. eine Ableitung des Signals und eine Multiplikation mit dem Signalwert bzw. Signal aufweist. Vorzugsweise weisen derartige Terme Ableitungen mit nur niedriger Ordnung auf, insbesondere nur Ableitungen bis zur zweiten Ordnung, was einfache Berechnungen mit nur wenigen Berechnungsschritten aus Multiplikationen und Additionen ermöglicht. Vorteilhafterweise werden die Terme bzw. die Ableitungen mit Wichtungsfaktoren gewichtet, wobei die Wichtungsfaktoren nur eine Auflösung weniger Bit benötigen. Für die jeweiligen konkreten Anwendungsfälle können die Wichtungsfaktoren und ein reduzierter Satz aus Termen mit Ableitungen ausgewählter Ordnung in einfacher Art und Weise empirisch ermittelt werden. Insbesondere bietet sich ein Verfahren an, bei dem eine nicht-iterative und divisionsfreie Berechnung des pulsweiten-modulierten Signals durch einfache Additionen und Multiplikationen durchgeführt wird. Dies ermöglicht eine deutliche Reduzierung der erforderlichen Berechnungsschritte und Rechenleistung gegenüber den bekannten Verfahren. Neben einer Berechnung im Zeitraum oder Frequenzraum ist vorteilhafterweise auch eine Berechnung im Raum der z-Transformierten möglich.

Besonders vorteilhaft mit Blick auf den Rechnungsaufwand ist eine Überabtastung mit Hilfe eines Überabtastfilters in einem ersten Schritt vor dem Umwandeln des digitalen kodierten Signals in das digitale pulsweiten-modulierte Signal und eine weitere Überabtastung danach. Dies ermöglicht, in dem ersten Schritt eine Überabtastung nur in dem Umfang durchzuführen, wie dies für das Umwandeln erforderlich ist. Erst in einem zweiten Schritt wird durch die weitere Überabtastung ein resultierender Überabtastwert erzielt, welcher für die weitere Signalverarbeitung beispielsweise in einem Noise Shaper oder einem PWM-Generator erforderlich ist. Dieser Aspekt weist auch einen eigenständigen erfinderischen Gehalt auf.

Bevorzugt wird insbesondere eine Vorrichtung mit einer Überabtasteinrichtung zum Überabtasten eines digitalen kodierten Signals, insbesondere pulskodierten Signals, mit einer Schaltungsanordnung zum Berechnen eines pulsweiten-modulierten Signals oder einer Vorstufe davon und mit einem Generator zum Bereitstellen eines pulsweiten-modulierten Ausgangssignals, wobei die Vorrichtung vorteilhafterweise eine zweite Überabtasteinrichtung aufweist, welche der Schaltungsanordnung nachgeschaltet ist, wobei das Produkt der Überabtastfaktoren der Überabtasteinrichtungen vor und nach der Schaltungsanordnung mindestens einem Wert eines erforderlichen Überabtastfaktors zum Bereitstellen einer PWM-Wiederholungsrate für das pulsweiten-modulierte Ausgangssignal aufweist.

Ein Ausführungsbeispiel wird nachfolgend anhand der Zeichnung näher erläutert. Es zeigen:

Fig. 1          schematisch Komponenten für eine PCM-zu-PWM-Umwandlung; und

Fig. 2A, 2B     Amplitudenspektren einer PCM-zu-PWM-Umwandlung gemäß dem UPWM-Verfahren gegenüber einer Umwandlung mit einer Anordnung und Verfahrensweise gemäß Fig. 1.

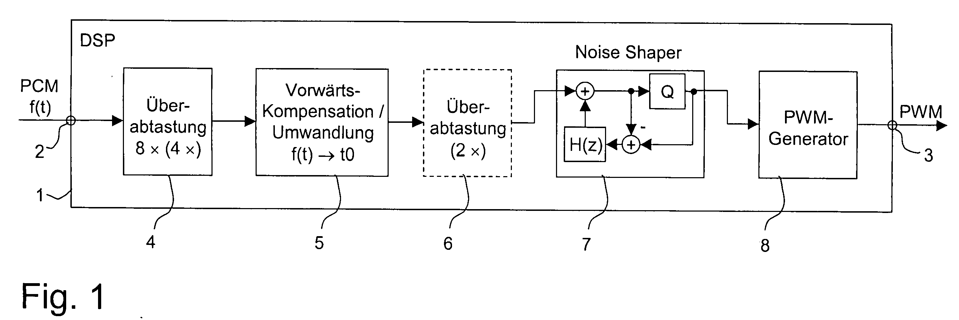

Wie aus Fig. 1 ersichtlich, besteht ein digitaler Signalprozessor (DSP 1) aus einer Vielzahl von Komponenten, wobei eine praktische Umsetzung auch alternative, zusätzliche oder weniger Komponenten aufweisen kann. Natürlich können die einzelnen Komponenten auch als separate Bauelemente oder als integrierter Baustein sowie auch als entsprechend bereitgestelltes Softwareprogramm zum Betreiben einer Rechnereinrichtung bereitgestellt sein.

Über einen Signaleingang 2 werden digitale Signale in den digitalen Signalprozessor 1 eingegeben. Diese digitalen Signale sind insbesondere pulskodierte modulierte Signale (PCM-Signale), beispielsweise Musiksignale von einer Musikwelle wie einer CD (Kompaktdisk). Über einen Signalausgang 3 werden pulsweiten-modulierte Signale bzw. Daten (PWM-Signale) ausgegeben, wobei die PWM-Signale in dem digitalen Signalprozessor aus den eingegebenen digitalen Signalen erzeugt werden. Weitere nicht dargestellte Anschlüsse des digitalen Signalprozessors 1 dienen beispielsweise zu Steuerzwecken und zum Anlegen einer Betriebsspannung.

Das digitale pulskodierte modulierte Signal wird vom Signaleingang 2 zu einer Überabtasteinrichtung 4, die auch als Oversampling Filter bezeichnet wird, geleitet und hinsichtlich der Abtastrate den Erfordernissen der nachfolgenden Umwandlung angepasst. Beim dargestellten Ausführungsbeispiel erfolgt eine 8-fache Überabtastung. Das derart bearbeitete Signal bzw. die Signalwerte werden einer Schaltungsanordnung 5 zur Vorwärtskompensation zum Berechnen des digitalen pulweiten-modulierten Signals PWM aus dem pulskodierten modulierten Signal PCM zugeführt. In dieser Schaltungsanordnung 5 erfolgt die Berechnung, wobei vorzugsweise überwiegend oder nur Multiplikationen und Additionen/Subtraktionen verwendet werden.

Das umgewandelte Signal wird vorzugsweise dann einem sog. Noise Shaper 7 zugeführt, welcher eine Rauschformung bzw. Rauschreduzierung vornimmt. Das derart bearbeitete Signal wird einem PWM-Generator 8 zugeführt, welcher das eigentliche pulsweiten-modulierte Signal bereitstellt. Das derart bearbeitete Signal wird dann dem Signalausgang 3 als pulsweiten-moduliertes Signal PWM zugeführt.

Bei der dargestellten Ausführungsform wird das vorwärtskompensierte Signal aus der Schaltungsanordnung 5 zum Umwandeln nach dem Umwandeln einer weiteren Überabtasteinrichtung 6 zugeführt, in welcher eine nochmalige Überabtastung durchgeführt wird. Das nochmals überabgetastete Signal wird dann dem Noise Shaper 7 oder direkt dem PWM-Generator zugeführt. Diese Vorgehensweise bietet die Möglichkeit in der ersten Überabtasteinrichtung 4 eine geringere Überabtastung, z.B. eine 4-fache, anstelle einer 8-fachen Überabtastung vorzunehmen. Diese erste Überabtastung wird so gewählt, dass die Abtastrate bzw. Stützstellenrate für die Umwandlung in der Schaltungsanordnung 5 ausreichend ist, so dass entsprechend der reduzierten Umwandlungsrate weniger Berechnungsschritte durchzuführen sind. Die zweite Überabtasteinrichtung 6 erhöht dann die Abtastrate auf die Erfordernisse der weiteren Daten-Signalverarbeitung im Noise Shaper 7 und/oder im PWM-Generator 8. Eine solche Aufsplittung der Überabtastung auf zwei voneinander getrennte Bauteile bzw. Verfahrensschritte vor bzw. nach der Umwandlung des digitalen Signals ist prinzipiell auch bei anderen Verfahren zur Umwandlung als dem vorliegend beschriebenen Verfahren vorteilhaft anwendbar. Als Überabtastfilter können für sich bekannte FIR- oder IIR-Verfahren und -Anordnungen sowie andere bekannte Interpolationsverfahren verwendet werden (FIR: Finite Impulse Response; IIR: Infinite Impulse Response).

Gemäß eigenständiger erfinderischer Ausgestaltung wird somit ein Nach-Überabtastfilter vorgeschlagen, welcher nach der PCM-zu-PWM-Umwandlung eingesetzt wird, so dass ein rechentechnisch komplexer PCM-zu-PWM-Wandler mit der geringst möglichen Signalrate und einem nachgeschalteten einfachen Nach-Überabtastfilter eingesetzt werden kann, um trotzdem die letztendlich erforderliche PWM-Pulsrate bzw. PWM-Wiederholungsrate zu erzielen. Dies reduziert die erforderliche Verarbeitungsleistung für PCM-zu-PWM-Wandler in hohem Maße. Beim dargestellten Ausführungsbeispiel wird die Komplexität eines 8-fach-Überabtastfilters 4 durch den Einsatz eines 4-fach-Überabtastfilters 4 vor und eines 2-fach-Überabtastfilters 6 nach der Umwandlung erzielt. Bei diesem Beispiel reduziert sich neben der erforderlichen Berechnungsleistung auch die Verarbeitungszeit für die PCM-zu-PWM-Umwandlung, da nur ein Signal bzw. eine Datenfolge mit der halben Signalrate zu verarbeiten ist.

In dem dargestellten Noise Shaper 7 (Rauschumformer) kann eine für sich bekannte Rauschformung durchgeführt werden. In für sich bekannter Art und Weise wird das Eingangssignal des Noise Shapers 7 z.B. einem Additionsglied zugeführt, dessen Ausgang zum subtrahierenden Eingang eines weiteren Additionsgliedes geführt wird. Außerdem liegt das Signal des Ausgangs des Additionsgliedes an einem Quantisierer Q an. Dessen Ausgangssignal wird aus dem Noise Shaper 7 ausgegeben und außerdem dem zweiten Eingang des weiteren Additionsglieds angelegt. Der Ausgang des weiteren Additionsglieds leitet das anliegende Signal bzw. den anliegenden Signalwert einem Bauelement bzw. einem Verfahrensschritt zum Anwenden einer allgemeinen Übertragungsfunktion H(z) zu. Der Ausgangswert wird dem zweiten Eingang des ersten Additionsglieds zugeführt.

Bei der Umwandlung in der Schaltungsanordnung 5 zum Umwandeln des pulskodierten Signals PCM zu dem pulsweiten-modulierten Signal PWM werden eine Verfahrensweise bzw. eine Schaltungsanordnung gewählt, welche die inhärenten Nicht-Linearitäten des abschließenden PWM-Digital/Analog-Prozesses vorkompensieren. Vorteilhafterweise wird dabei ein nicht-iteratives Verfahren gewählt. Außerdem ist es möglich, bei dem Verfahren nur Multiplikationen und Additionen, ggf. Subtraktionen für die effiziente Verarbeitung in dem digitalen Signalprozessor zu verwenden. Dies ist besonders vorteilhaft, da Divisionen erheblich mehr Verarbeitungsleistung als Multiplikations- und Additions-Operationen erforderlich machen.

Verwendet wird bevorzugt eine Vorwärtskompensation der Nicht-Linearitäten auf Basis einer Schnittpunkt-Approximation durch Berechnung und Kombination von einzelnen Termen auf Basis des Eingangsignals bzw. der Eingangssignalwerte und deren Ableitungen n-ter Ordnung. Im Unterschied zum iterativen Prozess der WO/92/11699 wird ein nicht-iterativer Prozess verwendet, bei dem das digitale Signal f(t) mit seinen gewichteten Ableitungen n-ter Ordnung als lineare und nicht-lineare Terme für die Vorwärtskompensation verwendet werden. Die Pulsweite bestimmt sich insbesondere durch Gleichung 1:

$$Pulsweite(PWM) = a0 + f(t) \cdot \left( \sum_{i1} \sum_{i2} \sum_{i3} \cdots \sum_{in} b_{i1i2i3\cdots in} \cdot f(t)^{i1} \cdot f'(t)^{i2} \cdot f''(t)^{i3} \cdots f^{(n)}(t)^{in} \right)$$

Dabei stellen $a0$, $b_{i1}$, $b_{i2}$, $b_{i3}...b_{in}$ Wichtungsfaktoren dar, der Index i1, i2, ..... in einen Laufindex für den jeweils i-ten Datenwert des Signals bzw. Abtastwertes der zeitlichen Funktionsfolge f(t) des digitalen Eingangssignals dar und f', f'', ..... f$^{(n)}$ die erste, zweite, ..... n-te Ableitung der Funktion f(t) dar, welche die digitale Signalfolge repräsentiert.

Im Gegensatz zur WO 97/37433 werden die individuellen Komponenten nicht nachträglich mit linearen und zeitinvarianten Filtern gefiltert und stellen auch keine Taylor-Entwicklung der Nicht-Linearitäten dar.

Ein besonders bevorzugter Einsatz einer solchen Schaltungsanordnung bzw. eines entsprechenden Verfahrens liegt im Bereich von Audioanwendungen. Beispielhafte Daten sind diesbezüglich eine Audiobandbreite von 20 Hz .... 20 kHz bei einem Signal/Rauschabstand > 90 dB und einem THD+N-Wert < 0,1 % (THD+N: Total Harmonic Distortion + Noise). Für solche Anwendungsfälle kann die vorstehende Gleichung (1) vorzugsweise auf nur einige wenige signifikante Terme reduziert werden. Außerdem können die Wichtungsfaktoren a0, b0, b1, b2, .... ohne Quantisierungsfehler sogar mit einer nur geringen Bitauflösung realisiert werden.

Ein Beispiel für einen empirisch reduzierten Satz von Termen für eine Implementierung unter Verwendung von Termen bis zur Ableitung 2-ter Ordnung wird gegeben durch:

$$t0 = a0 + f(t)\left(b0 + b1f'(t) + b2f'(t)^2 + b3f(t) \cdot f''(t)\right). \qquad (2)$$

Dabei stehen f(t) für die Signalamplitude des digitalen Eingangssignals, f'(t) für die erste Ableitung dieses Signals f(t), f''(t) für die zweite Ableitung dieses Signals, a0, b0, b1, b2, b3 für Wichtungsfaktoren, vorliegend vorzugsweise empirisch bestimmte Konstanten, und t0 für die PWM-Pulsweite. Wie dies ersichtlich ist, finden Multiplikationen der ursprünglichen Signalamplitude bzw. des Eingangssignals nicht nur mit reinen Ableitungen n-ter Ordnung sondern auch mit Mischtermen statt, in denen beispielsweise Faktoren sowohl die Ableitung zweiter Ordnung als auch zusätzlich die Ableitung 0-ter Ordnung enthalten sind.

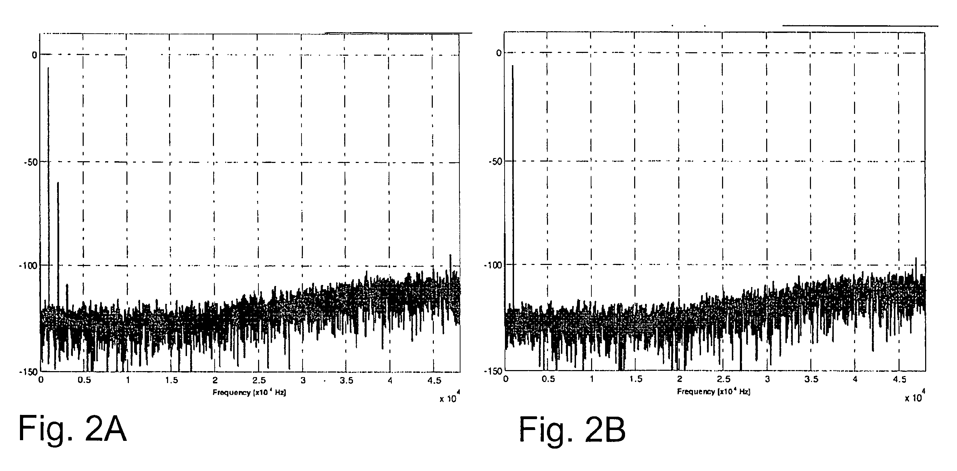

In den Figuren 2A und 2B sind zwei Amplitudenspektren für einen typischen Anwendungsfall im Audiobereich für das UWPM-Verfahren (Fig. 2A) bzw. eine Signalbearbeitung gemäß dem vorliegenden Verfahren (Fig. 2B) dargestellt. Das Amplitudenspektrum entspricht einem 1 kHz-Signal aus einem Frequenzbereich von 0 ... 50 kHz für einen entsprechenden PCM-zu-PWM-Wandler. Fig. 2A zeigt im niedrigen Frequenzbereich große harmonische Schwingungsanteile, wie sie bei einer Umwandlung gemäß UPWM üblicherweise auftreten. Diese können nachfolgend nicht mehr herausgefiltert werden, da sie sich im interessierenden Frequenzband befinden. Fig. 2B zeigt das Spektrum einer Umwandlung gemäß dem vorliegend beschriebenem Verfahren gemäß der empirisch reduzierten Gleichung (2). Ersichtlich ist die gute Linearität des Umwandlungsprozesses, wobei die großen harmonischen Schwingungen nicht auftreten, somit bei einer späteren Signalverarbeitung nicht oder nur in geringerem Maße berücksichtigt werden müssen.

Vorteilhaft ist der Einsatz der vorliegend beschriebenen PCMzu-PWM-Wandlung zum Kompensieren von Nicht-Linearitäten beim Einsatz in einem digitalen Verstärker. Vorteilhaft ist insbesondere ein digitaler Verstärker der die Kompensationstechnik verwendet und die vorgeschlagene Linearisierungstechnik zusätzlich in der Übertragungsfunktion H(z) des Rückkopplungs- bzw. Rückführungspfad des Noise Shapers realisiert.

Bei der bevorzugten Schaltungsanordnung werden somit vorzugsweise Multiplikationsglieder, Additionsglieder, ggf. Subtraktionsglieder und Zwischenspeicher verwendet, um den Einsatz von Divisionsgliedern vermeiden zu können.

Die nachfolgenden US-Patente und US-Patentanmeldungen werden bezugnehmend aufgenommen: 5,245,593, 5,559,467, 5,959,501, 6,014,055, 6,181,266 B1, 6,414,613 B1, 6,430,220 B1, 6,473,009 B1, 6,473,457 B1, 6,518,838 B1, 2002/0036579 A1, 2002/0041246 A1, 2002/0060605 A1, 2002/0135419 A1, 2003/0006838 A1, 2003/0031245 A1, 2003/0042868 A1.

**Patentansprüche**

1. Verfahren zum Umwandeln eines digitalen kodierten Signals (PCM, f(t)), insbesondere pulskodierten Signals, in ein pulsweiten-moduliertes Signal (PWM), bei dem das digitale Signal (PCM, f(t)) mit zumindest einer Ableitung (f'(t), f''(t),..., $f^{(n)}$(t)) des Signals (f(t)) multipliziert wird.

2. Verfahren nach Anspruch 1, bei dem das umgewandelte Signal (t0; PWM) aus linearen und/oder nicht-linearen Termen gebildet wird, wobei zumindest ein Teil der Terme eine Ableitung höherer Ordnung aufweist.

3. Verfahren nach Anspruch 1 oder 2, bei dem das umgewandelte Signal (t0; PWM) aus Termen mit Ableitungen niedriger, insbesondere maximal zweiter Ordnung gebildet wird.

4. Verfahren nach einem vorstehenden Anspruch, bei den Ableitungen (f'(t), f''(t),...) mit Wichtungsfaktoren (b0, ..., bn+1) gewichtet werden.

5. Verfahren nach Anspruch 4, bei dem die Wichtungsfaktoren (b0, b1, ....., bn+1) eine Auflösung weniger Bit aufweisen.

6. Verfahren nach einem vorstehenden Anspruch, bei dem für das Umwandeln ein empirisch reduzierter Satz aus Termen verwendet wird, insbesondere gemäß

$$t0 = a0 + f(t)\left(b0 + b1 f'(t) + b2 f'(t)^2 + b3 f(t) \cdot f''(t)\right),$$

wobei f(t) für die Signalamplitude des digitalen Eingangssignals steht, f'(t) für die erste Ableitung dieses Signals f(t), f''(t) für die zweite Ableitung dieses Signals, a0, b0, b1, b2, b3 für Wichtungsfaktoren.

7. Verfahren nach einem vorstehenden Anspruch, bei dem die Berechnung zum Umwandeln nicht-iterativ und divisionsfrei durch Additionen und Multiplikationen durchgeführt wird.

**8.** Verfahren zum Umwandeln eines digitalen kodierten Signals (PCM), insbesondere pulskodierten Signals, in ein pulsweiten-moduliertes Signal (PWM), insbesondere nach einem Verfahren nach einem der vorstehenden Ansprüche, bei dem zum Erzielen einer für das pulsweiten-modulierte Signal ausreichenden Abtastrate eine Überabtastung des digitalen Signals zu einem erforderlichen Überabtastfaktor durchgeführt wird,

**dadurch gekennzeichnet, dass**

eine Überabtastung mit einem Überabtastfaktor vor und eine Überabtastung mit einem weiteren Überabtastfaktor nach dem Umwandeln derart durchgeführt wird, dass das Produkt der Überabtastfaktoren vor und nach dem Umwandeln des digitalen Signals in das pulsweiten-modulierte Signal mindestens dem Wert des abschließend erforderlichen Überabtastfaktors entspricht.

**9.** Vorrichtung zum Umwandeln eines digitalen kodierten Signals (PCM, f(t)), insbesondere pulskodierten Signals, in ein pulsweiten-moduliertes Signal (PWM, t0), insbesondere mit einem Verfahren nach einem der Ansprüche 1 - 9, mit einer Schaltungsanordnung (5) zum Berechnen des pulsweiten-modulierten Signals aus Termen mit Ableitungen ($f'(t)$, $f''(t)$, ..., $f^{(n)}(t)$) des digitalen Signals ($f(t)$) und Multiplikationen der Ableitungen mit dem digitalen Signal ($f(t)$).

**10.** Vorrichtung nach Anspruch 9, bei der die Schaltungsanordnung (5) zum Berechnen des pulsweiten-modulierten Signals ausschließlich Multiplikationsglieder, Additionsglieder und Zwischenspeicher aufweist.

**11.** Vorrichtung nach Anspruch 9 oder 10, bei der die Schaltungsanordnung (5) ohne Divisionsglieder zum Berechnen der Umwandlung aufgebaut ist.

**12.** Vorrichtung insbesondere nach einem der Ansprüche 9-11 und/oder zum Durchführen eines Verfahrens nach einem der Ansprüche 1-8, mit

- einer Überabtasteinrichtung zum Überabtasten eines digitalen kodierten Signals (PCM) insbesondere pulskodierten Signals,
- einer Schaltungsanordnung (5) zum Berechnen eines pulsweiten-modulierten Signals (PWM) oder einer Vorstufe davon und
- einem Generator zum Bereitstellen eines pulsweiten-modulierten Ausgangssignals (PWM),

   **gekennzeichnet durch**

- eine zweite Überabtasteinrichtung (6), welche der Schaltungsanordnung (5) nachgeschaltet ist, wobei das Produkt der Überabtastfaktoren der Überabtasteinrichtungen (4, 6) vor und nach der Schaltungsanordnung (5) mindestens einem Wert eines erforderlichen Überabtastfaktors zum Bereitstellen einer PWM-Wiederholungsrate für das pulsweiten-modulierte Ausgangssignal (PWM) entspricht.

Fig. 1

Fig. 2A

Fig. 2B